# EUROPÄISCHE PATENTSCHRIFT

(11) **EP 2 160 836 B1**
(45) Veröffentlichungstag und Bekanntmachung des Hinweises auf die Patenterteilung: **01.01.2020**
(21) Anmeldenummer: 08761117.4
(22) Anmeldetag: 17.06.2008
(51) Int. Cl.: H03K 17/96

(54) **SCHALTVORRICHTUNG**
SWITCH DEVICE
DISPOSITIF DE COMMUTATION

(30) Priorität: 22.06.2007 DE 102007029324; 27.08.2007 DE 102007040604
(43) Veröffentlichungstag der Anmeldung: 10.03.2010
(73) Patentinhaber: Huf Hülsbeck & Fürst GmbH & Co. KG, 42551 Velbert (DE)
(72) Erfinder: MÖNIG, Stefan, 58322 Schwelm (DE); BRAUNER, Christof, 45130 Essen (DE); THRONBERENS, Stefan, 86559 Adelzhausen (DE); FALKENBERG, Andreas, 42579 Heiligenhaus (DE); POLAN, Ingo, 97525 Schwäbheim (DE); DYCKERS, Harald, 41515 Grevenbroich (DE)
(74) Vertreter: Vogel, Andreas
(86) Internationale Anmeldenummer: PCT/EP2008/057631
(87) Internationale Veröffentlichungsnummer: WO 2009/000705

(56) Entgegenhaltungen:
- EP-A- 0 232 137
- EP-A- 1 469 428
- WO-A-02/37516
- WO-A-2006/056459
- WO-A1-2006/056459
- DE-A1- 10 126 670
- DE-A1- 19 962 778
- DE-C1- 4 330 917
- JP-A- 10 162 685
- US-A- 5 636 729
- US-A1- 2006 120 790

## Beschreibung

Die Erfindung betrifft eine Schaltvorrichtung zum Ein- bzw. Ausschalten eines Verbrauchers, insbesondere eines Motors od. dgl. in einem Fahrzeug, mit einem Gehäuse, einem Betätigungselement, einem Schaltelement und einem Display, wobei das Display auf dem Betätigungselement angeordnet ist, das Schaltelement durch das Betätigungselement aktivierbar ist, mittels des Schaltelements wenigstens ein Schaltsignal für eine Steuereinheit erzeugbar ist.

In der DE 101 64 558 A1 ist ein Zündschalter beschrieben, der zum Starten oder Abschalten eines Fahrzeugmotors dient. Der Zündschalter ist in der Nähe einer Lenksäule angeordnet und weist einen, in einem Gehäuse angeordneten, beweglichen Körper auf. Darüber hinaus ist in dem Zündschalter ein Schaltkörper integriert, der den beweglichen Körper beweglich hält und zum Detektieren einer Verschiebung des beweglichen Körpers dient. Des Weiteren befindet sich ein Anzeigemittel zum Anzeigen eines Zustandes des Fahrzeuges in der Nähe des beweglichen Körpers. Bei solcherart Zündschaltern schiebt der Fahrer mit seinem Finger den beweglichen Körper in das Gehäuse ein, wodurch der Schaltkörper den Motor startet oder abschaltet. Als nachteilig hat es sich bei solcherart von Zündschaltern erwiesen, dass diese aufgrund des langen Einschubweges nur eine geringe Bedienerfreundlichkeit aufweisen und die komplexe Mechanik durch äußere Umwelteinflüsse leicht in ihrer Funktion gestört werden kann.

Die Schrift EP 1 469 428 A1 offenbart eine Schaltvorrichtung mit einem Gehäuse, einem Betätigungselement und zumindest einem Schaltelement. Ferner offenbart die Schrift WO 2006/056459 eine Schaltvorrichtung für ein Kraftfahrzeug mit einem Gehäuse, einem Betätigungselement und zumindest einem Schaltelement.

Außerdem offenbart die Schrift WO02/37516A eine Schaltvorrichtung mit einem Piezoschalter und mit optischer und/oder mechanischer Rückmeldung des Schaltvorganges.

Es ist Aufgabe der vorliegenden Erfindung, eine Schaltvorrichtung zum Ein- bzw. Ausschalten eines Verbrauchers zu schaffen, bei der die genannten Nachteile vermieden werden, insbesondere eine preiswerte und kompakte Schaltvorrichtung zum Ein- bzw. Ausschalten eines Verbrauchers bereitzustellen, die eine leichte und benutzerfreundliche Bedienung sicherstellt.

Zur Lösung dieser Aufgabe wird eine Schaltvorrichtung zum Ein- bzw. Ausschalten eines Verbrauchers mit den Merkmalen des Anspruches 1 vorgeschlagen. In den abhängigen Ansprüchen sind bevorzugte Weiterbildungen ausgeführt.

Es ist erfindungsgemäß vorgesehen, dass das Schaltelement ein Piezoschalter ist, wobei der Piezoschalter derart angeordnet ist, dass dieser das Schaltsignal bei einem Einschieben des Betätigungselements in das Gehäuse erzeugt.

Grundlage der Erfindung ist es, das Piezoschalter zum einen nur besonders kleine Schaltwege benötigen, um ausgelöst zu werden. Zum anderen sind Piezoschalter dafür bekannt, das Umwelteinflüsse diese gar nicht oder nur geringfügig beeinflussen. Folglich wird durch die Verwendung eines Piezoschalters eine besonders benutzerfreundliche und durch äußere Umwelteinflüsse unbeeinflussbare Schaltvorrichtung geschaffen.

Eine erste vorteilhafte Ausführungsvariante besteht darin, dass das Betätigungselement und das Display einstückig sind. Diese Ausführungsvariante zeichnet sich durch die Kombination eines Anzeigeelements - dem Display - mit dem Betätigungselement aus. Dadurch wird eine platzsparende Schaltvorrichtung erzeugt. Bei dieser Ausführungsvariante dient das Gehäuse des Displays als das Betätigungselement, welches in das Gehäuse eingeschoben wird. Ein Benutzer berührt folglich die Oberfläche des Displays und schiebt die mechanische Kombination aus Betätigungselement und Display in das Gehäuse ein, wodurch ein mechanischer Druck auf den Piezoschalter ausgeübt wird, der in einer Generierung des Schaltsignals resultiert. Durch die mechanische Kombination von Display und Betätigungselement reduziert sich nicht nur der Platzbedarf sondern auch die Anzahl der Elemente der Schaltvorrichtung. Letzteres steigert gleichzeitig die Zuverlässigkeit der Schaltvorrichtung.

Weiterhin ist es vorteilhaft, wenn die Schaltvorrichtung eine Einschublage und eine Nulllage aufweist, wobei die Einschublage durch das Einschieben des Betätigungselementes in das Gehäuse erreichbar ist und in der Nulllage das Schaltelement unbetätigt ist. Eine solcherart gestaltete Vorrichtung kann dadurch ergänzt werden, dass das Gehäuse einen Kraftspeicher aufweist, wobei der Kraftspeicher das Betätigungselement reversibel aus der Einschublage in die Nulllage überführt. Möchte ein Benutzer das Schaltsignal auslösen, schiebt dieser das Betätigungselement in das Gehäuse ein. In der so erreichten Einschublage generiert das Schaltelement ein Schaltsignal. Damit im Anschluss die erfindungsgemäße Schaltvorrichtung für eine erneute Generierung eines Schaltsignals benutzbar ist, schiebt der Kraftspeicher das Betätigungselement aus der Einschublage in die Nulllage zurück. Bei dem Kraftspeicher kann es sich vorteilhafterweise um eine Feder oder ein Elastomerelement handeln.

Eine die Erfindung verbessernde Maßnahme sieht vor, dass eine mechanische Deformation eines Piezoelementes des Piezoschalters das Schaltsignal, vorzugsweise ein elektrisches Schaltsignal, erzeugt. Das Piezoelement ist in dem Piezoschalter integriert und generiert das elektrische Schaltsignal. Bei dem Piezoelement kann es sich um einen Kristall oder eine Keramik handeln, die unter mechanischen Druck eine elektrische Spannung generieren. Der dazu benötigte Effekt der Piezoelektrizität basiert auf dem Phänomen, dass bei einer Verformung bestimmter Materialien auf deren Oberflächen eine elektrische Ladung auftritt. Für das Piezoelement nutzbare Kristall sind insbesondere Quarz, Lithiumniobat und Galliumorthophosphat. Weiterhin nutzbar sind Berlinit, Minerale der Turmalingruppe, Seignettesalz und alle Ferroelektrika, wie Bariumtitanat (BTO). Ebenfalls für die Verwendung in dem Piezoelement geeignet sind Keramiken aus synthetischen, anorganischen, ferroelektrischen und polykristallinen Werkstoffen, wie etwa Blei-Zirkonat-Titanate (PZT) und Blei-Magnesium-Niobate (PMN).

Eine weitere vorteilhafte Ausführungsvariante zeichnet sich dadurch aus, dass das Display mindestens eines der folgenden Mittel verwendet: eine Leuchtdiode (LEDs), eine Organische Leuchtdiode (OLEDs), eine Flüssigkristallanzeige (LCDs), einen Plasmabildschirm, eine Kathodenstrahlröhre, ein Surface-Conduction Electron-Emitter Display (SED) oder einen Feldemissionsbildschirm (FED). Eine lichtemittierende Diode (LED) ist ein Halbleiterbauteil, das inkohärentes Licht mit einem schmalen Spektrum emittiert. Die Wellenlänge des emittierten Lichtes hängt ab von den Halbleiterbauteilen sowie möglichen Dotierungen. Die ebenfalls nutzbare organische lichtemittierende Diode (OLED) ist ein spezieller Typ einer LED, in welcher die lichtemittierende Schicht aus organischen Komponenten geformt ist. Eine Flüssigkristallanzeige basiert auf der Verwendung spezieller Flüssigkristalle, welche die Polarisationsrichtung von Licht beeinflussen können, um Zeichen, Symbole oder Bilder darzustellen. Solcherart LCD-Bildschirme bestehen aus einer Mehrzahl von Segmenten, in welchen jeweils individuell die Orientierung der Flüssigkristalle mit einem elektrischen Feld gesteuert werden kann. Ein SED-Bildschirm weist eine ähnliche Funktionalität wie ein Kartodenstrahlbildschirm auf. Doch an Stelle eines einzelnen Elektronenemitters verwendet einen SED-Bildschirm in jedem einzelnen Subpixel ein Emitter. Ein Vorteil solcher Art gestalteter Bildschirme ist die schnelle Reaktionszeit sowie der erreichbare Kontrast. Die Auswahl, welcher der aufgezählten Typen in einer Schaltvorrichtung jeweils Verwendung finden soll, hängt im Allgemeinen von dem Einsatzort bzw. den Einsatzbedingungen ab. Ist die Schaltvorrichtung starken Umwelteinflüssen ausgesetzt, so hat es sich als vorteilhaft erwiesen, insbesondere LEDs oder LCD-Anzeigen zu verwenden. Die genannten Mittel sind auch durch starke Umwelteinflüsse, wie etwa Feuchtigkeit, nicht zu beeinträchtigen und erlauben folglich die Verwendung der erfindungsgemäßen Schaltvorrichtung auch in Geländefahrzeugen oder Schiffen. Ist die Schaltvorrichtung nur geringen Umwelteinflüssen ausgesetzt, soll aber eine größere Anzahl von Informationen darstellen, können insbesondere SED oder FED-Displays Verwendung finden.

Um eine platzsparende Schaftvorrichtung zu erzielen ist das Schaltelement folienartig ausgeformt. Dabei ist das Schaltelement zwischen dem Gehäuse und dem Display angeordnet. Das Piezoelement des Piezoschalters kann aus einem Quarz oder einer Keramik hergestellt sein, eine Höhe von nur einigen Millimetern aufweisen und zwischen dem Betätigungselement und dem Gehäuse angeordnet sein. Durch die folienartige Ausgestaltung des Schaltelementes kann insbesondere die gesamt Rückseite des Betätigungselementes mit dem Piezoschalter versehen werden. Dadurch ist sichergestellt, dass auch bei einer Berührung in einem Randbereich des Betätigungs- elementes das Schaltsignal zuverlässig generiert wird.

Das erfindungsgemäße Schaltelement soll von einem Benutzer berührt werden, um ein Schaltsignal auszulösen. Die entsprechende Berührung soll mittels des Betätigungselementes auf dem Piezoschalter übertragen werden. Folglich hat es sich als vorteilhaft erwiesen, wenn das Betätigungselement eine etwa fingergroße Grundfläche aufweist und kappenartig ausgestaltet ist. Auf diesem Betätigungselement kann das Display angeordnet sein. Eine weitere vorteilhafte Ausführungsform zeichnet sich dadurch aus, dass das Gehäuse ein Lager aufweist, wobei das Display in dem Lager angeordnet ist. Aus anatomischen Gründen kann das Lager des Gehäuses das Display und das Betätigungselement kranzartig umgeben. Dadurch erfüllt das Lager nicht nur die Aufgabe, das Betätigungselement in seiner Bewegung zwischen der Einschublage und der Nulllage zu führen, sondern schützt auch das Display vor Einwirkungen im Randbereich.

Zusätzlich kann das Lager mit einem Gleitelement des Betätigungselementes zusammenwirken. Das Gleitelement ist an den Seitenbereichen des Betätigungselementes angeordnet und ermöglicht das nahezu reibungsfreie Einschieben des Betätigungselementes in das Gehäuse. Darüber hinaus dichtet das Gleitelement das Betätigungselement gegenüber dem Lager ab, so dass keine Umwelteinflüsse wie Schmutz oder Feuchtigkeit in das Gehäuseinnere eindringen können.

Eine die Erfindung verbessernde Maßnahme sieht vor, dass auf dem Display ein Zustand des Fahrzeuges anzeigbar ist, insbesondere, dass auf dem Display eine Start- und/oder Stoppbereitschaft des Motors anzeigbar ist. Moderne Kraftfahrzeuge weisen eine Vielzahl von Sensoren und Aktuatoren auf, welche individuell einstellbar sind. Um die Benutzerfreundlichkeit eines Fahrzeuges zu erhöhen kann auf dem Display der erfindungsgemäßen Schaltvorrichtung die Einstellungen der einzelnen Sensoren und Aktuatoren des Kraftfahrzeuges angezeigt werden, sodass eine einfache und eingängige Darstellung aller wichtigen Einstellungen möglich ist. Insbesondere das Anzeigen einer Start- und/oder Stoppbereitschaft des Motors auf dem Display hat sich als vorteilhaft herausgestellt. Moderne Fahrzeugmotoren sind oftmals sehr leise, weshalb nicht immer durch einen Geräuschpegel direkt erkennbar ist, ob der Motor läuft. Eine entsprechende Anzeige durch die Schaltvorrichtung erlaubt einem Benutzer im Kraftfahrzeug somit eine optische Kontrolle, ob der Motor läuft oder nicht. Dadurch wird verhindert, dass ein Startvorgang für den Motor ein zweites Mal ausgelöst wird, was zu einer Beschädigung eines Motoranlassers führen könnte.

Eine weitere die Erfindung verbessernde Maßnahme sieht vor, dass das Display über ein Bussystem mit wenigstens einer Informationsquelle verbunden ist, wobei das Bussystem zum uni- und/oder bidirektionalen Austausch mindestens einer Information zwischen dem Display und der Informationsquelle dient, insbesondere dass die Information auf dem Display anzeigbar ist. Eine solcherart ausgestaltete Schaltvorrichtung kann weiter dadurch verbessert werden, dass die Information mittels des Bussystems über eine serielle oder eine parallele Architektur übermittelbar ist. Alternativ oder ergänzend kann vorgesehen sein, dass die Informationsquelle mindestens eine der folgenden ist: ein GPS-System, ein Radio, ein Handy, eine Heizung, insbesondere eine Standheizung, ein Einparksystem, ein Fahrzeug- oder ein Motormanagement-System.

Durch die beschriebene Kombination der verbessernden Maßnahmen ist es einem Benutzer möglich, über die Einstellung und/oder den Zustand verschiedener Informationsquellen unterrichtet zu werden. Dazu kann insbesondere auf dem Display eine Anzahl von Piktogrammen angezeigt werden, die jeweils mit einer individuellen Informationsquelle verbunden sind. So ist es einem Benutzer leicht möglich, beispielsweise die Einstellung der Klimaanlage zu überprüfen. Es bedarf dazu nicht eines separat ausgestalteten Anzeigeelementes für diese Informationsquelle. Vielmehr kann die erfindungsgemäße Schaltvorrichtung dazu dienen, sämtliche Informationen der Informationsquellen für einen Benutzer einfach zugängig darzustellen.

Ferner weist die Schaltvorrichtung eine Schnittstelle auf, wobei die Schnittstelle eine der folgenden Technologien aufweist: Wireless LAN (IEEE 802.11), FireWire (IEEE 1394), USB (Universal Serial Bus), HDMI (High Definition Multimedia Interface), IrDA (Infrared Data Association), Bluetooth, Unifink, ATA/ATAPI (Advanced Technology Attachment with Packet Interface), IEEE 488 oder IEEE 1284. Die aufgezählten Schnittstellen können insbesondere für eine Kommunikation zwischen der Schaltvorrichtung und einer externen Rechnereinheit genutzt werden. So können Informationen der Informationsquellen, Daten eines Motors oder eines Schließsystems auf die externe Rechnereinheit übertragen werden. Dieses hat sich insbesondere für eine Suche nach möglichen Fehlern bei Inspektionen in Werkstätten als vorteilhaft erwiesen.

Eine weitere die Erfindung verbessernde Maßnahme sieht vor, dass die Schaltvorrichtung an wenigstens einer der folgenden Stellen im Fahrzeug anordbar ist: an einem Lenkrad, insbesondere im Bereich eines Emblems oder von Prall- oder Griffflächen, an einem Schalthebel, an einer Mittelkonsole, an einer Multifunktionsbedieneinheit am Armaturenbrett, an einer Innenverkleidung der Türen, am Dachhimmel, am Innenrückfahrspiegel oder links bzw. rechts vom Lenkrad. Von dieser Schaltvorrichtung gehen nur ein oder mehrere elektrische Leiter aus, so dass eine einfach Verkabelung selbst im Lenkrad möglich ist. Somit muss die erfindungsgemäße Schaltvorrichtung nicht versteckt und kaum zugänglich, wie z.B. ein mechanisches Lenkradschloss angeordnet werden. Damit kann der Bedienungskomfort beim Starten des Motors oder dergleichen deutlich erhöht werden, da die ergonomischen Belange des Fahrers berücksichtigt werden können.

Die vorliegende Aufgabe der Erfindung wird ebenfalls gelöst durch ein Sicherheitssystem zur Aktivierung bzw. Deaktivierung einer Anlage oder eines Gerätes, insbesondere eines Lenkradschlosses oder eines Motors in einem Fahrzeug, mit einer Schaltvorrichtung nach einem der vorhergehenden Ansprüche, und einem mobilen ID-Geber, wobei zwischen der Schaltvorrichtung und dem ID-Geber eine Datenübertragung stattfindbar ist, und einer Steuereinheit, die die Datenübertragung zwischen der Schaltvorrichtung und dem mobilen ID-Geber steuert.

Dieses Sicherheitssystem ist mit einer Schaltvorrichtung nach einem der Ansprüche 1 bis 15 und einem mobilen ID-Geber ausgestattet, wobei zwischen der Schaltvorrichtung und dem ID-Geber eine Datenübertragung stattfinden kann. Zusätzlich ist in dem Sicherheitssystem eine Steuereinheit vorgesehen, die zumindest die Datenübertragung zwischen der Schaltvorrichtung und dem mobilen ID-Geber steuert. Bei diesem Sicherheitssystem muss sich der Fahrer bzw. Bediener des Fahrzeuges nicht aktiv identifizieren, um eine Freischaltung oder Aktivierung des Systems zu bewirken. Allein durch die Betätigung der Schaltvorrichtung, insbesondere des Betätigungselements wird der Identifizierungsvorgang automatisch gestartet, wobei die Datenübertragung dazu genutzt wird, das codierte Weck- bzw. Aktivierungssignal von der Schaltvorrichtung auf den ID-Geber zu übertragen. Nachdem der mobile ID-Geber dieses Wecksignal empfangen und überprüft hat, sendet er den eigentlichen Identifizierungscode an das Sicherheitssystem zurück. Dieses kann einerseits auch über die Datenübertragung stattfinden oder über eine zusätzliche Empfangseinheit, die per Funk die Identifikationsdaten von dem mobilen ID-Geber empfängt und diese an die Steuereinheit weiter leitet. Die Steuereinheit vergleicht dann die Identifikationsdaten mit den vorgegebenen Identifikationsdaten und nimmt dann bei einer positiven Identifikation eine entsprechende Steuerung der einzelnen Verbraucher oder Geräte vor, je nach dem, welche Schaltstellung oder welches Schaltsignal der Schaltvorrichtung vorliegt. Somit kann beispielsweise das elektrische Lenkradschloss entriegelt werden und das Motormanagement-System freigeschaltet werden, um den Motor in einem Fahrzeug zu starten.

Weitere Maßnahmen und Vorteile der Erfindung ergeben sich aus den Ansprüchen, der nachfolgenden Beschreibung und den Zeichnungen. In den Zeichnungen ist die Erfindung in mehreren Ausführungsbeispielen dargestellt. Es zeigen:
- Figur 1: eine schematische Schnittzeichnung einer erfindungsgemäßen Schaltvorrichtung in einer Nulllage,
- Figur 2: die Schaltvorrichtung aus Figur 1 in einer Einschublage,
- Figur 3: eine schematische Schnittzeichnung einer weiteren Ausführungsform der erfindungsgemäßen Schaltvorrichtung in einer Nulllage,
- Figur 4: die Schaltvorrichtung und ein Bussystem und
- Figur 5: eine Frontansicht der erfindungsgemäßen Schaltvorrichtung.

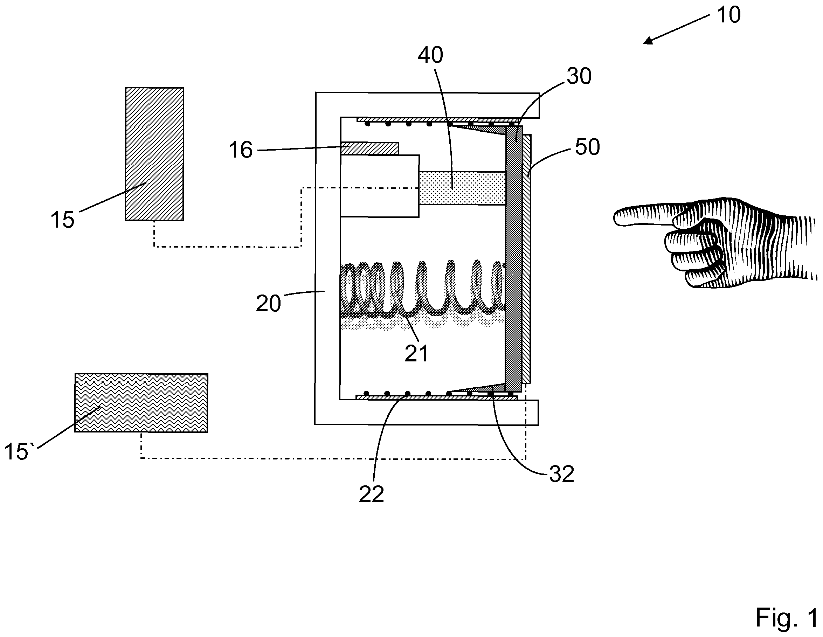

Der Rahmen der Erfindung wird durch den Schutzumfang der Ansprüche definiert. Der Gegenstand jeglichen Bezugs auf "Ausführungsformen", "Ausführungsvarianten", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden. In Figur 1 ist eine erste vorteilhafte Ausgestaltung der Schaltvorrichtung 10 zum Ein- bzw. Ausschalten eines Verbrauchers, insbesondere eines Motors oder dergleichen, in einem Fahrzeug dargestellt. Die Schaltvorrichtung 10 weist ein Gehäuse 20, ein Betätigungselement 30, ein Schaltelement 40 und ein Display 50 auf. Dabei ist das Display 50 auf dem Betätigungselement 30 angeordnet und das Schaltelement 40 durch das Betätigungselement 30 aktivierbar. Mittels des Schaltelementes 40 kann wenigstens ein Schaltsignal 17 für eine Steuereinheit 15,15' erzeugt werden. Erfindungsgemäß ist es vorgesehen, dass das Schaltelement 40 ein Piezoschalter ist. Dieser Piezoschalter ist derart angeordnet, dass das Schaltsignal 17 bei einem Einschieben 31 des Betätigungselementes 30 in das Gehäuse 20 erzeugt wird.

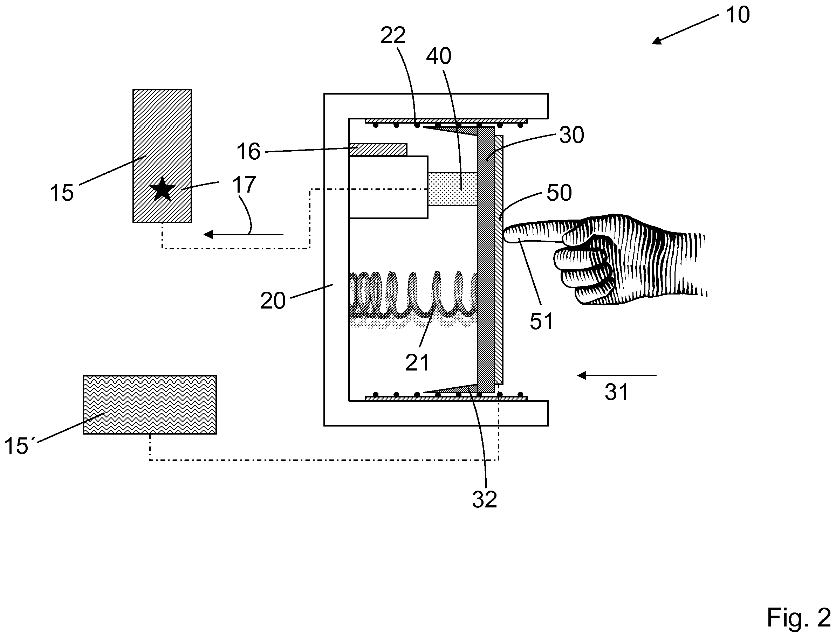

Die Figur 2 verdeutlicht das Einschieben 31 des Betätigungselementes 30 in das Gehäuse 20. Man erkennt, dass das Betätigungselement 30 gegenüber dem Gehäuse 20 verschoben wird und dabei eine Kraft auf dem Piezoschalter 40 ausübt. Durch die mechanische Deformation des Piezoschalters 40 wird das vorzugsweise elektrische Signal 17 generiert. Eine im Gehäuse angeordneter Kraftspeicher 21 - hier eine Feder - sorgt dafür, dass nach dem Einschieben 31 das Betätigungselement 30 reversibel wieder in eine Nulllage ausgeschoben wird. Als Nulllage ist dabei die Stellung des Betätigungselementes 30 bezeichnet, bei der kein Schaltsignal 17 durch den Piezoschalter 40 ausgelöst wird.

In dem Gehäuse 20 ist ein Lager 22 mit entsprechenden Lagerelementen angeordnet. Innerhalb dieses Lagers 22 ist das Betätigungselement angeordnet, wobei die Lagerelemente für eine Führung des Betätigungselementes 30 bei der Überführung aus der Einschub- in die Nulllage bzw. umgekehrt sorgen. Dazu weist das Betätigungselement 30 mit den Lagerelementen zusammenwirkende Gleitelement 32 auf.

Wie die Figur 2 verdeutlicht, wird bei der Betätigung der erfindungsgemäßen Schaltvorrichtung sowohl das Betätigungselement 30 als auch das mit diesem verbundene Display 50 in das Gehäuse eingeschoben. Folglich sind das Betätigungselement 30 und das Display 50 fest verbunden. Insbesondere sind beide einstückig ausgeformt. So ist es zum Beispiel denkbar, dass das Betätigungselement 30 gleichzeitig als Gehäuse für das Display 50 dient. In diesem Fall wird bei einer Betätigung des Betätigungselementes 30 gleichzeitig das Display 50 in das Gehäuse 20 eingeschoben. Ein Benutzer muss folglich die Oberfläche des Displays berühren 51, um dieses in das Gehäuse 20 einzuschieben 31.

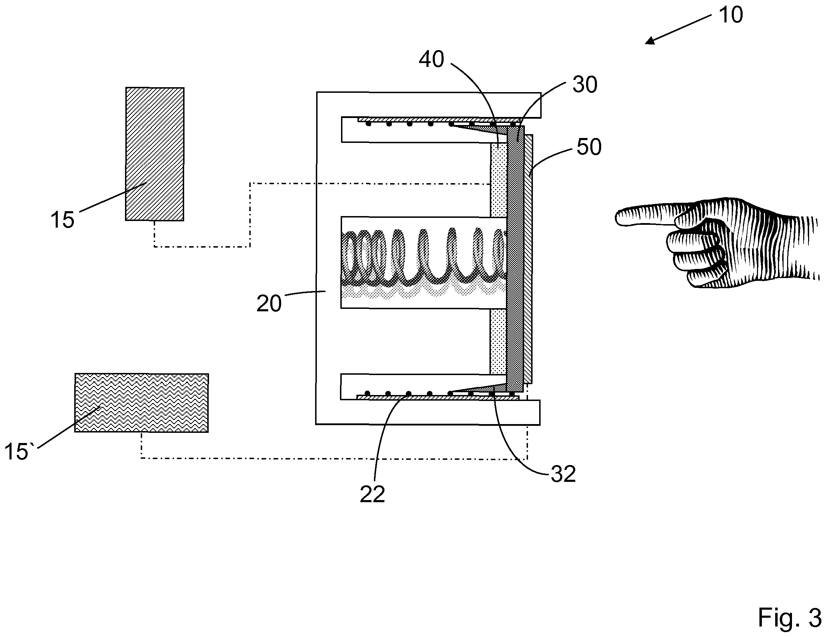

Eine weitere vorteilhafte Ausführungsvariante der Schaltvorrichtung 10 ist in Figur 3 dargestellt. Dabei bedeckt das Schaltelement/der Piezoschalter 40 fast die gesamte Unterseite des Betätigungselementes 30. Insbesondere ist das Schaltelement/der Piezoschalter 40 der erfindungsgemässen Schaltvorrichtung folienartig ausgeformt sein. Diese Ausführungsvariante hat den Vorteil, dass unabhängig von einem Ort einer Berührung einer Oberfläche des Betätigungselementes 30 immer sichergestellt ist, dass ein Schaltsignal 17 erzeugt wird. Es wird so verhindert, dass das Betätigungselement 30 bei einer Betätigung 31 verkantet und so kein Schaltsignal 17 erzeugt wird. Darüber hinaus erlaubt dieser Art der Ausgestaltung des Schaltelementes 40 eine Verringerung einer Bauhöhe der Schaltvorrichtung 10, da der folienartige Aufbau nur einen geringen Platzbedarf aufweist. Darüber hinaus ist der Einschubweg, welchen das Betätigungselement 30 zurücklegen muss bis das Schaltsignal 17 bei dem Einschieben 31 generiert wird, sehr gering. Die so erreichte gesteigerte Bedienerfreundlichkeit der erfindungsgemäßen Schaltvorrichtung 10 ist kombiniert mit einer reduzierten Platzanforderung. So kann die Schaltvorrichtung 10 insbesondere noch nachträglich in Fahrzeuge integriert werden, ohne das besondere Anforderungen an den zu Verfügung stehenden Bauraum gestellt werden müssen.

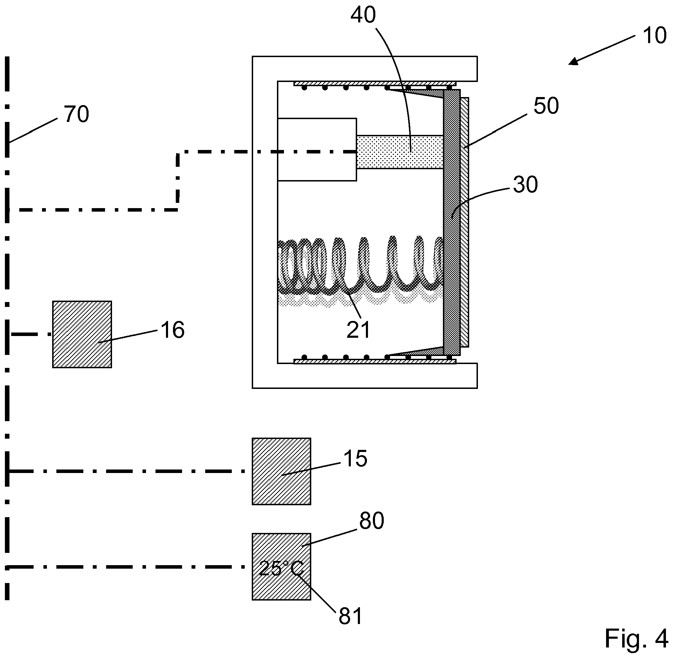

Wie Figur 4 verdeutlicht, wird die erfindungsgemäße Schaltvorrichtung 10 an ein Bussystem 70 angeschlossen, welches die Schaltvorrichtung 10 mit einer Informationsquelle 80 verbindet. Dabei ermöglicht das Bussystem 70 einen uni- und/oder bidirektionalen Austausch mindestens einer Information 81. Bei dem Bussystem 70 kann es sich um ein leitungsgebundenes oder um ein funkwellenbasiertes Bussystem handeln. Folglich können von der Informationsquelle 80, wie etwa einem Sensor und/oder Aktuator, Informationen 81 an das Display 50 über das Bussystem 70 gesandt werden. Bei diesen Informationen 81 kann es sich um Einstellungen der Aktuatoren oder Messwerte der Sensoren handeln. In einer vorteilhaften Variante dieser Ausführungsform können die Informationen 81 dann auf dem Display 50 angezeigt werden, um eine visuelle Darstellung zu erzielen. Um die Information 81 zu übermitteln, hat es sich als vorteilhaft erwiesen, wenn das Bussystem 70 eine serielle oder eine parallele Architektur aufweist. Eine parallele Architektur bezeichnet dabei eine digitale Übertragung bei der mehrere Bits gleichzeitig - also parallel - übertragen werden. Im Gegensatz dazu wird bei der seriellen Datenübertragung die Information bitweise hintereinander über das Daten-übertragungsmedium übertragen. Vorteilhafterweise weist das Bussystem eine der folgenden parallelen Architekturen auf: ATA (Advanced Technology Attachment), GPIB (General Purpose Interface Bus) oder HIPPI (High Performance Parallel Interface). Soll eine serielle Systemarchitektur Verwendung finden hat es sich als vorteilhaft erwiesen, eine der folgenden Architekturen zu benutzen: ACCESS.bus, ASI-Bus, ByteFlight, Controller Area Network (CAN), Europäischer Installationsbus (EIB), ISYGLT (Innovativ SYstem für die GebäudeLeitTechnik), KNX, Local Control Network (LCN), FlexRay, Universal Serial Bus (USB), FireWire, eSATA (External Serial ATA), Profibus, MOST-Bus, Time-Triggered Protocol (TTP), LIN-Bus, ControlNet, INTERBUS, MIL-Bus, SafetyBUS p oder Spacewire.

Im Gehäuse 20 der dargestellten Schaltvorrichtung 10 oder extern am Bussystem 70 kann weiterhin eine Rechnereinheit 16 angeordnet sein. Dabei kann es sich um einen Mikrocontroller, FPGA (Field programmable gate array) oder einen Digital Signal Processor (DSP) handeln. Solcherart Rechnereinheiten 16 können zur Steuerung sowohl des Displays 50 als auch zur Kommunikation mit dem Bussystem 70 dienen. Darüber hinaus können in der Rechnereinheit 16 auch Grafikkarten oder sonstige elektronische Einheiten zur Steuerung des Displays 50 integriert sein. In den Figuren 1 und 2 ist die Rechnereinheit 16 innerhalb des Gehäuses 20 angeordnet. Dieses hat sich insbesondere dann als vorteilhaft erwiesen, wenn das Display 50 der erfindungsgemäßen Schaltvorrichtung 10 auch dazu genutzt wird, Informationen anderer Informationsquellen darzustellen. In diesem Fall kann die Rechnereinheit 16 nicht nur für eine Steuerung des Displays 50 sondern auch für den Informationsfluss über das Bussystem 70 sorgen. Darüber hinaus können in der Rechnereinheit 16 Computerprogrammprodukte integriert sein, welche die jeweils angeschlossenen Informationsquellen erkennen und in regelmäßigen Zeitabschnitten nach Informationen befragen. Dadurch ist eine zentrale Steuerung des Datenflusses innerhalb des Bussystems 70 durch die Rechnereinheit 16 sichergestellt. Im Gegensatz dazu ist in Figur 4 die Rechnereinheit 16 dezentral angeordnet und über das Bussystem 70 mit der Schaltvorrichtung 10 verbunden. Da moderne Kraftfahrzeuge häufig schon über eine eigene Rechnereinheit 16 verfügen, kann es der Fall sein, dass es keiner weiteren in der Schaltvorrichtung 10 integrierten Rechnereinheit 16 bedarf. Folglich muss die Schaltvorrichtung 10 nur mit dem Bussystem 70 verbunden werden, um eine Auswertung des Schaltsignals 17 sicher zu stellen.

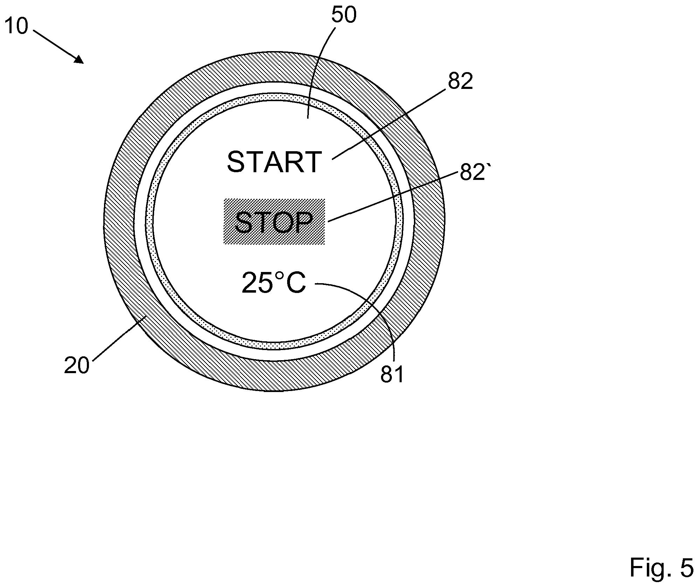

In Figur 5 ist eine Aufsicht auf eine Vorderseite der erfindungsgemäßen Schaltvorrichtung 10 dargestellt. Das kranzförmige Gehäuse 20 umschließt das Display 50. Auf dem Display 50 ist zum einen die Information 81 der Informationsquelle 80 dargestellt. In dem gezeigten Ausführungsbeispiel handelt es sich um die aktuelle Temperatur der Klimaanlage. Darüber hinaus sind eine Start- und/oder Stoppbereitschaft 82, 82' eines Motors des Kraftfahrzeuges angezeigt. In dem Ausführungsbeispiel ist angenommen, dass der Motor läuft. Folglich kann durch die Schaltvorrichtung 10 nur ein Stoppsignal 82' übersandt werden. Um dieses Faktum optisch zu bestätigen, ist die Stoppbereitschaft 82' auf dem dargestellten Display 50 farblich hinterlegt. Folglich ist einem Benutzer klar, dass ein Eindrücken des Displays 50 zu einem entsprechenden Anhalten des Motors führt.

### Bezugszeichenliste

- 10: Schaltvorrichtung

- 15, 15': Steuereinheit
- 16: Rechnereinheit
- 17: Schaltsignal

- 20: Gehäuse
- 21: Kraftspeicher
- 22: Lager für das Betätigungselement 30

- 30: Betätigungselement
- 31: Einschieben des Betätigungselementes
- 32: Gleitelement

- 40: Schaltelement

- 50: Display
- 51: Berührung des Displays
- 52: Oberfläche des Display

- 70: Bussystem

- 80: Informationsquelle
- 81: Information
- 82, 82': Start- und/oder Stoppbereitschaft

## Patentansprüche

1. Schaltvorrichtung (10) zum Ein- bzw. Ausschalten eines Verbrauchers, insbesondere eines Motors in einem Fahrzeug,
mit einem Gehäuse (20), einem Betätigungselement (30), einem Schaltelement (40) und einem Display (50), wobei
das Display (50) auf dem Betätigungselement (30) angeordnet ist,
das Schaltelement (40) durch das Betätigungselement (30) aktivierbar ist,
mittels des Schaltelements (40) wenigstens ein Schaltsignal (17) für eine Steuereinheit (15,15') erzeugbar ist,
wobei das Schaltelement (40) ein Piezoschalter ist, wobei der Piezoschalter derart angeordnet ist, dass dieser das Schaltsignal (17) bei einem Einschieben (31) des Betätigungselements (30) in das Gehäuse (20) erzeugt,
wobei das Betätigungselement (30) und das Display (50) beide einstückig ausgeformt sind,
wobei das Schaltelement (40) folienartig ausgeformt ist, wobei das Schaltelement (40) zwischen dem Gehäuse (20) und dem Display (50) angeordnet ist, wobei das Display (50) über ein Bussystem (70) mit wenigstens einer Informationsquelle (80) verbunden ist, wobei das Bussystem (70) zum uni und/oder bidirektionalen Austausch mindestens einer Information (81) zwischen dem Display (50) und der Informationsquelle (80) dient, wobei die Information (81) auf dem Display (50) anzeigbar ist,
wobei auf dem Display (50) ein Zustand des Fahrzeugs anzeigbar ist, wobei auf dem Display (50) eine Start- und/oder Stoppbereitschaft (82, 82') des Motors anzeigbar ist.

2. Schaltvorrichtung (10) nach einem der Ansprüche 1,
**dadurch gekennzeichnet,**
**dass** die Schaltvorrichtung (10) eine Einschublage und eine Nulllage aufweist, wobei die Einschublage durch das Einschieben (31) des Betätigungselementes (30) in das Gehäuse (20) erreichbar ist und in der Nulllage das Schaltelement (40) unbetätigt ist.

3. Schaltvorrichtung (10) nach Anspruch 2,
**dadurch gekennzeichnet,**
**dass** das Gehäuse (20) einen Kraftspeicher (21) aufweist, wobei der Kraftspeicher (21) das Betätigungselement (30) reversibel aus der Einschublage in die Nulllage überführt.

4. Schaltvorrichtung (10) nach einem der vorhergehenden Ansprüche,
**dadurch gekennzeichnet,**
**dass** eine mechanische Deformation eines Piezoelementes des Piezoschalters das Schaltsignal (17), vorzugsweise ein elektrisches Schaltsignal (17), erzeugt.

5. Schaltvorrichtung (10) nach einem der vorhergehenden Ansprüche,
**dadurch gekennzeichnet,**
**dass** das Display (50) mindestens eines der folgenden Mittel verwendet: eine Leuchtdiode , LED, eine Organische Leuchtdiode, OLED, eine Flüssigkristallanzeige, LCD, einen Plasmabildschirm, eine Kathodenstrahlröhre, ein Surface-Conduction Electron-Emitter Display, SED, oder einen Feldemissionsbildschirm, FED.

6. Schaltvorrichtung (10) nach einem der vorhergehenden Ansprüche,
**dadurch gekennzeichnet,**
**dass** das Gehäuse (20) ein Lager (22) aufweist, wobei das Display (50) in dem Lager (22) angeordnet ist.

7. Schaltvorrichtung (10) nach Anspruch 1,
**dadurch gekennzeichnet,**
**dass** die Information (81) mittels des Bussystems (70) über eine serielle oder eine parallel Architektur übermittelbar ist.

8. Schaltvorrichtung (10) nach einem der Ansprüche 1 oder 7,
**dadurch gekennzeichnet,**
**dass** die Informationsquelle (80) mindestens eine der folgenden ist: ein GPS-System, ein Radio, ein Handy, eine Heizung, insbesondere eine Standheizung, ein Einparksystem, ein Fahrzeug- oder ein Motormanagement-System.

9. Schaltvorrichtung (10) nach einem der vorhergehenden Ansprüche,
**dadurch gekennzeichnet,**
**dass** die Schaltvorrichtung (10) eine Schnittstelle aufweist, insbesondere dass die Schnittstelle eine der folgenden Technologien aufweist: Wireless LAN IEEE ,802.11, FireWire, IEEE 1394, USB, Universal Serial Bus, HDMI ,High Definition Multimedia Interface. IrDA, Infrared Data Association. Bluetooth, Unilink, ATA/ATAPI, Advanced Technology / Attachment with Packet Interface, IEEE 488 oder IEEE 1284.

10. Schaltvorrichtung (10) nach einem der vorhergehenden Ansprüche,
**dadurch gekennzeichnet,**
**dass** die Schaltvorrichtung (10) an wenigstens einer der folgenden Stellen im Fahrzeug anordbar ist: an einem Lenkrad, insbesondere im Bereich eines Emblems oder von Prall- oder Griffflächen, an einem Schalthebel, an einer Mittelkonsole, an einer Multifunktionsbedieneinheit am Armaturenbrett, an einer Innenverkleidung der Türen, am Dachhimmel, am Innenrückfahrspiegel oder links bzw. rechts vom Lenkrad.

11. Sicherheitssystem zur Aktivierung bzw. Deaktivierung einer Anlage oder eines Gerätes, insbesondere eines Lenkradschlosses oder eines Motors in einem Fahrzeug, mit
einer Schaltvorrichtung (10) nach einem der vorhergehenden Ansprüche, und einem mobilen ID-Geber, wobei zwischen der Schaltvorrichtung (10) und dem ID-Geber eine Datenübertragung stattfindbar ist, und
einer Steuereinheit (15,15'), die die Datenübertragung zwischen der Schaltvorrichtung (10) und dem mobilen ID-Geber steuert.

## Claims

1. Switching device (10) for switching on or off a consumer, in particular an engine in a vehicle,
having a housing (20), an actuating element (30), a switching element (40) and a display (50), wherein
the display (50) is arranged on the actuating element (30),
the switching element (40) can be activated by the actuating element (30),
at least one switching signal (17) for a control unit (15, 15') can be generated by means of the switching element (40),
the switching element (40) being a piezo switch, the piezo switch being arranged in such a way that it receives the switching signal (17) on insertion (31) of the actuating element (30) into the housing (20),
wherein the actuating element (30) and the display (50) are both integrally formed, wherein the switching element (40) is formed like a foil,
the switching element (40) being arranged between the housing (20) and the display (50), the display (50) being connected via a bus system (70) to at least one information source (80), the bus system (70) serving for an uni and/or bidirectional exchange of at least one piece of information (81) between the display (50) and the information source (80), the information (81) being displayable on the display (50),
wherein a state of the vehicle can be indicated on the display (50), wherein a starting and/or stopping readiness (82, 82') of the engine can be indicated on the display (50).

2. Switching device (10) according to claim 1,
**characterized**
**in that** the switching device (10) has an insertion position and a zero position, the insertion position being attainable by insertion (31) of the actuating element (30) into the housing (20), and the switching element (40) not being actuated in the zero position.

3. Switching device (10) according to claim 2,
**characterized**
**in that** the housing (20) has an energy store (21), the energy store (21) reversibly transferring the actuating element (30) from the insertion position into the zero position.

4. Switching device (10) according to one of the preceding claims,
**characterized**
**in that** a mechanical deformation of a piezo element of the piezo switch generates the switching signal (17), preferably an electrical switching signal (17).

5. Switching device (10) according to one of the preceding claims,
**characterized**
**in that** the display (50) uses at least one of the following means: a light emitting diode, LED, a plasma screen, a cathode ray tube, a surface conduction electron emitter display, SED, or a field emission screen, FED.

6. Switching device (10) according to one of the preceding claims,
**characterized**
**in that** the housing (20) has a bearing (22), the display (50) being arranged in the bearing (22).

7. Switching device (10) according to claim 1,
**characterized**
**in that** the information (81) can be transmitted by means of the bus system (70) via a serial or a parallel architecture.

8. Switching device (10) according to any of claims 1 or 8,
**characterized**
**in that** the information source (80) is at least one of the following: a GPS system, a radio, a mobile phone, a heater, in particular a parking heater, a parking system, a vehicle management system or an engine management system.

9. Switching device (10) according to one of the preceding claims,
**characterized**
**in that** the switching device (10) has an interface, in particular in that the interface has one of the following technologies: Wireless LAN, IEEE 802.11, FireWire, IEEE 1394, USB, Universal Serial Bus, HDMI, High Definition Multimedia Interface, IrDA, Infrared Data Association, Bluetooth, Unilink, ATA/ATAPI, Advanced Technology Attachment with Packet Interface, IEEE 488 or IEEE 1284.

10. Switching device (10) according to one of the preceding claims,
**characterized**
**in that** the switching device (10) can be arranged at at least one of the following points in the vehicle: on a steering wheel, in particular in the region of an emblem or of impact or grip surfaces, on a switching lever, on a center console, on a multifunction operating unit on the dashboard, on an interior trim for the doors, on the roof lining, on the interior rear-view mirror or on the left or right of the steering wheel.

11. Safety system for activating or deactivating an installation or a device, in particular a steering wheel lock or an engine in a vehicle, with
a switching device (10) according to one of the preceding claims, and
a mobile ID transponder, wherein it is possible for data transmission to take place between the switching device (10) and the ID transponder, and
a control unit (15, 15') which controls the data transmission between the switching device (10) and the mobile ID transponder.

## Revendications

1. Dispositif de commutation (10) pour allumer ou éteindre un consommateur, en particulier un moteur dans un véhicule,
avec un boîtier (20), un élément d'actionnement (30), un élément de commutation (40) et un affichage (50), dans lequel
l'affichage (50) est arrangé sur l'élément d'actionnement (30),
l'élément de commutation (40) peut être activé par l'élément d'actionnement (30),
au moins un signal de commutation (17) pour une unité de commande (15, 15') peut être généré au moyen de l'élément de commutation (40), l'élément de commutation (40) étant un interrupteur piézoélectrique, l'interrupteur piézoélectrique étant disposé de manière à recevoir le signal de commutation (17) lors de l'insertion (31) de l'élément d'actionnement (30) dans le boîtier (20),
dans laquelle l'élément d'actionnement (30) et l'afficheur (50) sont tous deux formés d'un seul tenant,
dans laquelle l'élément de commutation (40) est formé comme une feuille,
l'élément de commutation (40) étant disposé entre le boîtier (20) et l'affichage (50), l'affichage (50) étant relié par l'intermédiaire d'un système de bus (70) à au moins une source d'information (80), le système de bus (70) servant à l'échange uni et/ou bidirectionnel d'au moins une information (81) entre l'affichage (50) et la source d'information (80), l'information (81) peut être affiché sur l'affichage (50),
dans laquelle un état du véhicule peut être indiqué sur l'affichage (50), dans lequel une disponibilité au démarrage et/ou à l'arrêt (82, 82') du moteur peut être indiquée sur l'affichage (50).

2. Dispositif de commutation (10) selon la revendication 1,
**caractérise**
**en ce que** le dispositif de commutation (10) présente une position d'insertion et une position zéro, la position d'insertion pouvant être atteinte par insertion (31) de l'élément d'actionnement (30) dans le boîtier (20) et l'élément de commutation (40) ne pouvant être actionné dans la position zéro.

3. Dispositif de commutation (10) selon la revendication 2,
**caractérise**
**en ce que** le boîtier (20) comporte un accumulateur d'énergie (21), l'accumulateur d'énergie (21) transférant de manière réversible l'élément d'actionnement (30) de la position d'insertion en position zéro.

4. Dispositif de commutation (10) selon l'une des revendications précédentes,
**caractérise**
**en ce qu'**une déformation mécanique d'un élément piézoélectrique d'interrupteur piézoélectrique génère le signal de commutation (17), de préférence un signal de commutation électrique (17).

5. Dispositif de commutation (10) selon l'une des revendications précédentes,
**caractérise**
**en ce que** l'afficheur (50) utilise au moins l'un des moyens suivants : une diode électroluminescente, une LED, un écran plasma, un tube cathodique, un afficheur à électrons à conduction de surface, SED, ou un écran à émission de champ, FED.

6. Dispositif de commutation (10) selon l'une des revendications précédentes,
**caractérise**
**en ce que** le boîtier (20) présente un palier (22), l'affichage (50) étant disposé dans le palier (22).

7. Dispositif de commutation (10) selon la revendication 1,
**caractérise**
**en ce que** l'information (81) peut être transmise au moyen du système de bus (70) via une architecture série ou parallèle.

8. Dispositif de commutation (10) selon l'une quelconque des revendications 1 ou 8,
**caractérise**
**en ce que** la source d'information (80) est au moins l'une des sources suivantes : un système GPS, une radio, un téléphone mobile, un chauffage, en particulier un chauffage de stationnement, un système de stationnement, un système de gestion de véhicule ou un système de gestion de moteur.

9. Dispositif de commutation (10) selon l'une des revendications précédentes,
**caractérise**
**en ce que** le dispositif de commutation (10) présente une interface, en particulier **en ce que** l'interface présente une des technologies suivantes : Wireless LAN, IEEE 802.11, FireWire, IEEE 1394, USB, Universal Serial Bus, HDMI, High Définition Multimedia Interface, IrDA, Infrared Data Association, Bluetooth, Unilink, ATA/ATAPI, Advanced Technology Attachment with Packet interface, IEEE 488 oder IEEE 1284.

10. Dispositif de commutation (10) selon l'une des revendications précédentes,
**caractérise**
**en ce que** le dispositif de commutation (10) peut être disposé en au moins un des points suivants dans le véhicule : sur un volant, en particulier dans la zone d'un emblème ou de surfaces d'impact ou de préhension, sur un levier de commutation, sur une console centrale, sur une unité de commande multifonction du tableau de bord, sur une garniture intérieure pour les portes, sur le revêtement du toit, sur le rétroviseur intérieur ou à droite ou à gauche du volant.

11. Système de sécurité pour activer ou désactiver une installation ou un dispositif, en particulier un antivol de direction ou un moteur dans un véhicule, avec
un dispositif de commutation (10) selon l'une des revendications précédentes, et
un transpondeur d'identification mobile, la transmission de données pouvant s'effectuer entre le dispositif de commutation (10) et le transpondeur d'identification, et
une unité de commande (15, 15') qui commande la transmission de données entre le dispositif de commutation (10) et le transpondeur mobile.
